Europäisches Patentamt

European Patent Office

Office européen des brevets

(19)

(11) EP 0 578 970 B1

(12) **EUROPÄISCHE PATENTSCHRIFT**

(45) Veröffentlichungstag und Bekanntmachung des Hinweises auf die Patenterteilung:
**26.08.1998 Patentblatt 1998/35**

(51) Int Cl.⁶: **G11C 8/00**, G06F 11/00

(21) Anmeldenummer: **93109301.7**

(22) Anmeldetag: **09.06.1993**

(54) **Verfahren zum Herstellen eines integrierten Halbleiterspeichers mit vorgegebener Speicherkapazität**

Fabrication method for an integrated semi-conductor memory with a predetermined storage capacity

Méthode de fabrication d'une mémoire à semi-conducteurs intégrée ayant une capacité de stockage prédéterminée

(84) Benannte Vertragsstaaten:
**AT DE FR GB IT NL**

(30) Priorität: **25.06.1992 DE 4220878**

(43) Veröffentlichungstag der Anmeldung:
**19.01.1994 Patentblatt 1994/03**

(73) Patentinhaber: **SIEMENS AKTIENGESELLSCHAFT**
**80333 München (DE)**

(72) Erfinder: **Savignac, Dominique, Dr. rer. nat.**
**85737 Ismaning (DE)**

(56) Entgegenhaltungen:
GB-A- 2 170 657        US-A- 3 715 735
US-A- 4 633 429

**Beschreibung**

Die Erfindung betrifft ein Verfahren zum Herstellen eines integrierten Halbleiterspeichers mit vorgegebener Speicherkapazität.

In der Halbleiter- und Computerindustrie ist es allgemein bekannt, daß eine Generation von Halbleiterspeichern, d.h. ein Halbleiterspeichertyp mit einer bestimmten Anzahl von Speicherzellen (=Speicherkapazität), nach drei Jahren von einer Nachfolgegeneration mit entsprechend größerer Speicherkapazität abgelöst wird. Die Nachfolgegenerationen unterscheiden sich von ihren jeweiligen Vorgängergenerationen im allgemeinen jedoch nicht nur in der Speicherkapazität, sondern auch in technologischer Hinsicht (z.B. Verwendung wesentlich kleinerer Strukturen, gänzlich andere Technologie (wie z.B. seinerzeit beim Übergang von NMOS-Speichern auf CMOS-Speichern), VMOS-Transistoren, Graben- und Stacked-Capacitor Zelle, HiC-Zelle, neue Gehäusearten), in schaltungstechnischer Hinsicht (z.B. Erzeugen der Substratvorspannung "on chip" anstelle einer früher üblichen externen Zuführung, mehrstufige Adressdecoder anstelle einstufiger Adressdecoder, Leseverstärker) und/oder in neuen Architekturen (z.B. Aufteilen in mehrere Zellenfelder, Einführen neuer Testmodi, neue Redundanzkonzepte). Zwischen Vorgänger- und Nachfolgergeneration bestehen also im allgemeinen außer Unterschieden in den Speicherkapazitäten auch sonstige, erhebliche Unterschiede.

Darüberhinaus ist es in der Halbleiter- und Computerindustrie auch allgemein bekannt, daß innerhalb einer Generation von Halbleiterspeichern Weiterentwicklungen stattfinden (sogenannte "Redesigns"), die im allgemeinen dem Ziele dienen, die für den Halbleiterchip benötigte Flache zu minimieren, um so Kosten senken zu können. Dies erfolgt in (verglichen mit einem Generationswechsel) kleineren Schritten, die z.B. in einem Verkleinern von Abmessungen, gegebenenfalls in einem Optimieren von Schaltungsteilen etc. bestehen, wobei jedoch der Halbleiterspeicher im Grundsatz, d.h. wenigstens in den Punkten Speicherkapazität und Architektur, unverändert bleibt gegenüber der in der jeweiligen Generation erstmals vorgestellten Version. Die einzelnen Redesign-Versionen werden meist als Shrink-, Supershrink-, Hypershrink-Version bezeichnet. Bei diesem Vorgehen kann naturgemäß im allgemeinen nur relativ wenig Chipfläche eingespart werden.

US-A-3 715 735 offenbart ein Verfahren zur Herstellung eines integrierten Halbleiterspeichers mit vorgegebener Speicherkapazität wobei unter Verwendung eines Layouts eines Halbleiterspeichers, welcher eine größere Speicherkapazität aufweist als die vorgegebene Speicherkapazität, ein entsprechender Halbleiterchip gefertigt wird. Dieses größere Layout und der entsprechende Halbleiterchip weisen mehrere Speicherzellenfelder auf. Für den herzustellenden kleineren Halbleiterspeicher wird nur ein der vorgegebenen Speicherkapazität entsprechender Teil dieser Speicherzellenfelder verwendet.

Aufgabe der vorliegenden Erfindung ist es, ein Verfahren der eingangs genannten Art anzugeben, bei dem es möglich ist, einen Halbleiterspeicher einer vorgegebenen Speicherkapazität herzustellen mit einem Layout, welches wesentlich weniger Chipfläche beansprucht als das Layout eines bereits vorhandenen, anderen Halbleiterspeichers der vorgegebenen Speicherkapazität.

Diese Aufgabe wird bei einem gattungsgemaßen Verfahren gelöst durch die kennzeichnenden Merkmale des Patentanspruches 1. Vorteilhafte Aus- und Weiterbildungen sind in Unteransprüchen gekennzeichnet.

Die Erfindung wird nachstehend anhand der Zeichnung näher erläutert. Es zeigen, jeweils stark schematisiert und reduziert auf die wesentlichen Teile:

Figur 1    das Layout eines Halbleiterspeichers mit einer höheren Speicherkapazität als der vorgegebenen,

Figur 2    das aus dem Layout nach Figur 1 hergestellte Layout eines herzustellenden Halbleiterspeichers mit der vorgegebenen Speicherkapazität,

Figur 3    den Blockdecoder eines Quadranten des Speichers nach Figur 1,

die Figuren 4 bis 7    jeweils den Blockdecoder eines entsprechenden Quadranten des Speichers nach Figur 2.

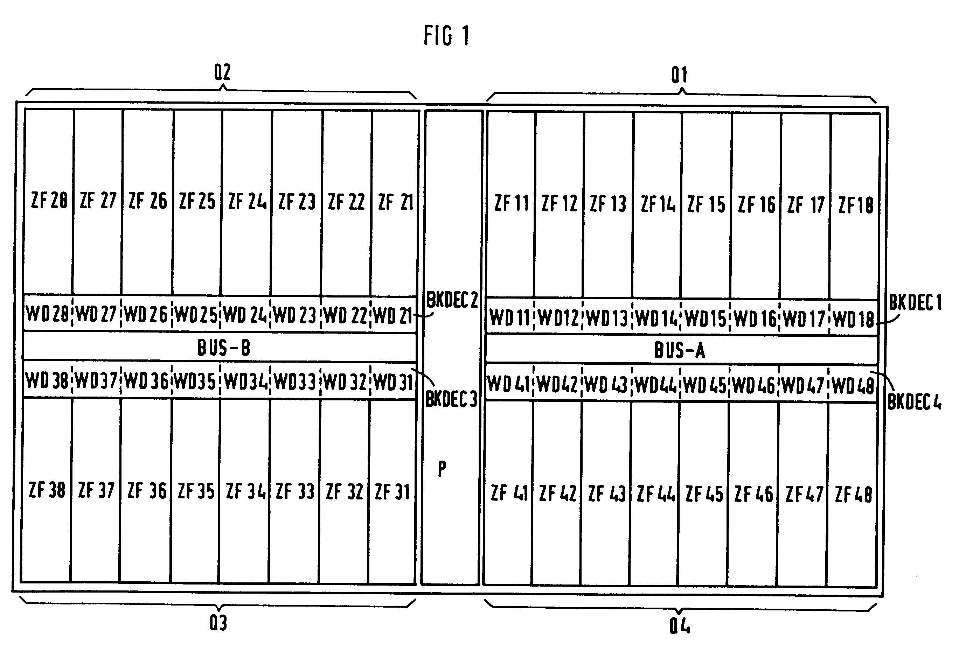

Figur 1 zeigt die für die vorliegende Erfindung wesentlichen Teile des Layouts eines integrierten Halbleiterspeichers, welcher eine höhere Speicherkapazität aufweist als der herzustellende Halbleiterspeicher und welches zu verwenden ist bei der Herstellung eines Halbleiterspeichers mit dem erfindungsgemäßen Verfahren. Es sei beispielhaft angenommen, daß der der Figur 1 entsprechende Halbleiterspeicher ein 16MB-DRAM sei und daß der herzustellende Halbleiterspeicher ein 4MB-DRAM sei. Von einer Darstellung der Anschlußpads wurde abgesehen, weil diese angenommenermaßen Bestandteil peripherer Schaltungsteile P seien.

Der Halbleiterspeicher mit dem Layout nach Figur 1 weist in vier Quadranten Q1 ... Q4 angeordnete, einander jeweils gleiche Zellenfelder ZF11 ... ZF18, ZF21 ... ZF28, ZF31 ... ZF38, ZF41 ... ZF48 auf. Jedes Zellenfeld ZF11 ... ZF48 enthält (in regelmäßiger Anordnung, wie allgemein bekannt) über Wort- und Bitleitungen adressierbare Speicherzellen sowie Wortleitungsdecoder, Leseverstärker und sonstige in einem Zellenfeld sich regelmäßig wiederholende Schaltungsteile wie z.B. Anordnungen zum Vorladen von Bitleitungen. Vorliegend ist angenommen, daß jedes Zellenfeld ZF11 ... ZF48 einen Bitleitungsdecoder enthält. Es ist jedoch auch möglich, daß ein Bitleitungsdecoder mehreren bis allen Zellenfeldern ZF11 ... ZF18 (ZF21 ... ZF28, ...) eines Quadranten Q1 (Q2, Q3, Q4) zugeordnet ist. Dies ist für die vorliegende Erfindung jedoch unerheblich. Jedem Quadranten Q1 ... Q4 ist ein Blockdecoder BKDEC1 ... 4 zugeordnet mit Blockdecodereinheiten WD11 ... WD18, WD21 ... WD28, WD31 ... WD38, WD41 ... WD48, von denen jede Bestandteil eines jeweiligen Zellenfeldes ZF11 ... ZF18, ... ist. Block-decoder dienen bekanntlich dazu, hinsichtlich der Wortleitungsadressierung ein Zellenfeld aus einer Anzahl von Zellenfeldern auszuwählen, so daß sich in Verbindung mit dem Wortleitungsdecoder des jeweiligen Zellenfeldes eine mindestens zwei-stufige Wortleitungsdecodierung ergibt.

Jeweils zwei Quadranten Q1, Q4 bzw. Q2, Q3 sind durch Bus-Leitungen BUS-A bzw. BUS-B voneinander getrennt. Die Bus-Leitungen BUS-A bzw. BUS-B führen im Betrieb Steuersignale, Auswahlsignale, Datensignale, um die Zellenfelder ZF11 ... ZF48 samt den zugehörigen Blockdecodern BKDEC1 ... 4 mit den entsprechenden Blockdecodereinheiten WD11 ... WD48 betreiben zu können.

Der Halbleiterspeicher mit dem Layout nach Figur 1 weist weiterhin periphere Schaltungsteile P auf. Die peripheren Schaltungsteile P dienen unter anderem einem Erzeugen und/oder Weiterleiten der Steuersignale, Auswahlsignale, Datensignale der Bus-Leitungen BUS-A, BUS-B sowie angenommenermaßen zur Auswahl eines oder mehrerer der Quadranten Q1 ... Q4. Sie enthalten beispielsweise die bereits genannten Anschlußpads sowie die allgemein üblichen Adreßpufferschaltungen, mittels derer die an einen Halbleiterspeicher anzulegenden externen Adreßsignale Ai einerseits zwischengespeichert werden und mittels der diese andererseits in interne, zueinander komplementäre Adreßsignale Bi, $\overline{Bi}$ umgewandelt werden. Die peripheren Schaltungsteile P sind in Figur 1 zwischen den einen durch die Bus-Leitungen BUS-A voneinander getrennten Quadranten Q1, Q4 und den anderen durch die Bus-Leitungen BUS-B voneinander getrennten Quadranten Q2, Q3 angeordnet. Dies ist wegen der sich dadurch ergebenden Signal führung (kurze Leitungslängen) zwar günstig, jedoch nicht notwendig für das noch zu beschreibende Aufführen der erfindungsgemäßen Lehre.

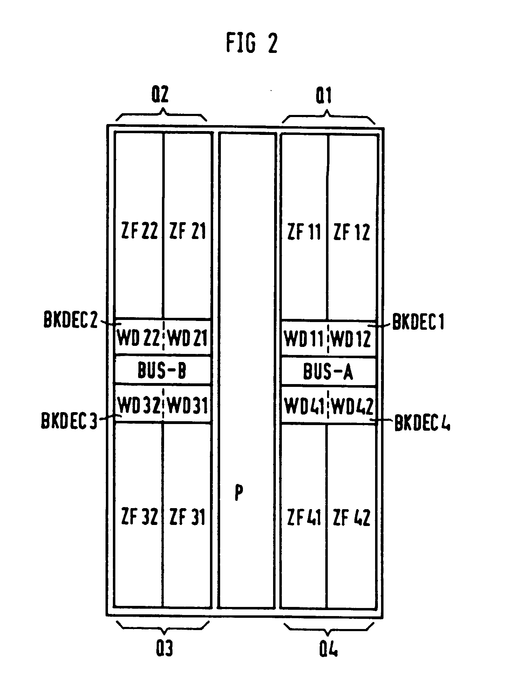

Figur 2 zeigt das Layout eines mit dem erfindungsgemäßen Verfahren hergestellten Halbleiterspeichers. Bei diesem Verfahren wird angenommen, daß der so herzustellende Halbleiterspeicher eine vorgegebene Speicherkapazität von 4MB aufweisen soll und daß dem Hersteller das Layout des Halbleiterspeichers nach Figur 1, d.h. z.B. eines solchen mit 16MB Speicherkapazität, zur Verfügung stehe. In anderen Worten ausgedrückt, bedeutet dies, daß jemand einen integrierten Halbleiterspeicher einer bestimmten Generation von Halbleiterspeichern (hier 4MB-DRAM) herstellen will und daß diesem das Layout der Nachfolgegeneration (hier 16MB-DRAM) dieser bestimmten Generation zur Verfügung steht. Selbstverständlich ist dabei, daß es sich bei beiden Generationen um Halbleiterspeicher derselben Art (z.B. DRAM) handelt.

Zum Herstellen des erfindungsgemäßen Halbleiterspeichers (mit z.B. 4MB Speicherkapazität) ist nun erfindungsgemäß vorgesehen, daß ein Layout erstellt und verwendet wird, das folgende Merkmale aufweist, wie in Figur 2 dargestellt: Aus dem Layout der Nachfolgegeneration (hier 16MB), wie es in Figur 1 beispielsweise dargestellt ist, schneidet man so viele Speicherzellenfelder heraus, wie es dem Unterschied in der Anzahl der Speicherzellen der Halbleiterspeicher der beiden Halbleiterspeichergenerationen entspricht (hier: 16MB - 4MB = 12MB = 3/4 der Speicherzellen des Halbleiterspeichers der Nachfolgegeneration = 3/4 der Zahl der Speicherzellenfelder dieses Halbleiterspeichers der Nachfolgegeneration). Die dabei übrig bleibenden Speicherzellenfelder (hier: 1/4 der ursprünglichen Anzahl der Speicherzellenfelder) verbindet man mit den restlichen Teilen des Layouts des Halbleiterspeichers der Nachfolgegeneration, wobei die restlichen Teile des Layouts den übrig bleibenden Speicherzellenfelder benachbart angeordnet werden, um Platz zu sparen, so daß nicht unnötigerweise leere Flächen entstehen. Für die Funktion des mit einem so geschaffenen Layout herzustellenden Halbleiterspeichers (4MB) nicht mehr benötigte Schaltungsteile außerhalb der verwendeten Speicherzellenfelder (z.B. Adresspuffer, Anschlußpads für externe Adreßsignale Ai) können dabei ebenfalls entfallen oder aber sie werden, falls nötig, schaltungsmäßig so geändert, daß sie beim Betrieb des solcherart hergestellten Halbleiterspeichers nicht störend wirken (z.B. Verbinden mit einem Punkt, der im Betrieb ein vorgegebenes, festes Potential führt).

Auf diese Weise steht ein Layout, wie es in Figur 2 dargestellt ist, für einen Halbleiterspeicher mit 4MB Speicherkapazität, unter Verwendung des Layouts eines Halbleiterspeichers (der gleichen Art, d.h. ebenfalls z.B. DRAM) mit 16MB Speicherkapazität gemäß Figur 1:

In einem ersten Schritt wird das Layout der peripheren Schaltungsteile P nach Figur 1 verwendet. Anschließend werden um das Layout der peripheren Schaltungsteile P herum, angeordnet auf dieselbe architektonische Art und Weise wie beim Speicher der Nachfolgegeneration (siehe Figur 1: im Beispiel also ebenfalls angeordnet in 4 Quadranten Q1 ... Q4), die Layouts von 1/4 der Speicherzellenfelder nach Figur 1 angeordnet. Damit enthalten, wie in Figur 2 dargestellt, der erste Quadrant Q1 die Speicherzellenfelder ZF11, ZF12; der zweite Quadrant Q2 die Speicherzellenfelder ZF21, ZF22; der dritte Quadrant Q3 die Speicherzellenfelder ZF31, ZF32 und der vierte Quadrant Q4 die Speicherzellenfelder ZF41, ZF42.

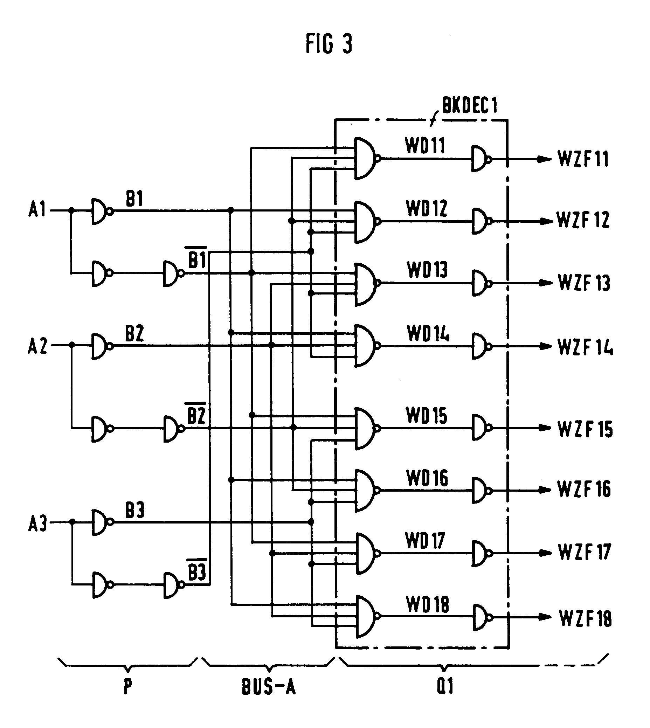

Mit übernommen aus dem Layout des Speichers der Nachfolgegeneration werden demzufolge auch, sofern vorhanden (wie in den Figuren 1, 2 angenommen), diejenigen Blockdecodereinheiten WD11, WD12, WD21, WD22, WD31, WD32, WD41, WD42 von Blockdecodern BKDEC1 ... 4, die Bestandteil der übernommenen Speicherzellenfelder ZF11 ... ZF42 sind: Der in Figur 1 dargestellte Halbleiterspeicher der Nachfolgegeneration enthält beispielsweise (aufgrund des dort gewählten Decodierschemas für die Wortleitungen) in jedem Quadranten (z.B. Q1) einen Blockdecoder (BKDEC1). Ein solcher Blockdecoder (z.B. BKDEC1) dient, wie allgemein bekannt, dazu, bezüglich der Adressierung von Wortleitungen eines (oder ggf. auch mehrere, was hier nicht angenommen wird aus Gründen der Einfachheit) der Zellenfelder des jeweiligen Quadranten (z.B. Q1) auszuwählen (z.B. Zellenfeld ZF17 im Quadranten Q1). Jeder der Blockdecoder BKDEC1 ... 4 enthält dazu, wie in Figur 1 angedeutet, Blockdecodereinheiten WD11 ... WD18 (bzw. WD21 ... WD28, WD31 ... WD38, WD41 ... WD48) in einer Anzahl, die der Anzahl der Zellenfelder ZF11 ... ZF18 (bzw. ZF21 ... ZF48) des betrachteten Quadranten Q1 (bzw. Q2, Q3, Q4) entspricht. Jede Blockdecodereinheit (z.B. WDII im ersten Quadranten Q1) ist dabei fest einem jeweiligen Zellenfeld (ZF11 entsprechend dem gewählten Beispiel) zugeordnet mittels eines Blockdecodersignals (z.B. WZF11), welches im Betrieb die Wortleitungsdecoder des betreffenden Zellenfeldes (z.B. ZF11) entsprechend aktiviert oder deaktiviert. Dies ist für den ersten Quadranten Q1 des Halbleiterspeichers der Nachfolgegeneration in Figur 3 gezeigt, wobei A1, A2, A3 an den Halbleiterspeicher von extern anzulegende Adreßsignale sind und wobei B1, $\overline{B1}$, B2, $\overline{B2}$, B3, $\overline{B3}$ interne Adreßsignale sind, die im Betrieb in den peripheren Schaltungsteilen P erzeugt werden in wahrer und invertierter Form mittels sogenannter Adreßpuffer (dargestellt als Inverter).

Da, wie bereits geschildert, beim erfindungsgemäßen Verfahren bei der Erstellung des Layouts des Halbleiterspeichers mit der vorgegebenen Speicherkapazität nur ein Teil der Zellenfelder des Halbleiterspeichers der Nachfolgegeneration in jedem Quadranten Q1 ... Q4 verwendet werden (in Figur 2: jeweils zwei Zellenfelder ZF11, ZF12 bzw. ZF21, ZF22; ZF31, ZF32; ZF41, ZF42), wird auch nur ein entsprechender Teil der Blockdecodereinheiten verwendet, nämlich die Blockdecodereinheiten WD11, WD12, WD21, WD22, WD31, WD32, WD41, WD42 (vgl. Figur 2). Weiterhin wird auch nur derjenige Teil der Busleitungen BUS-A, BUS-B verwendet, der entlang der verwendeten Speicherzellenfelder ZF11, ZF12, ZF41, ZF42 bzw. ZF21, ZF22, ZF31, ZF32 verläuft.

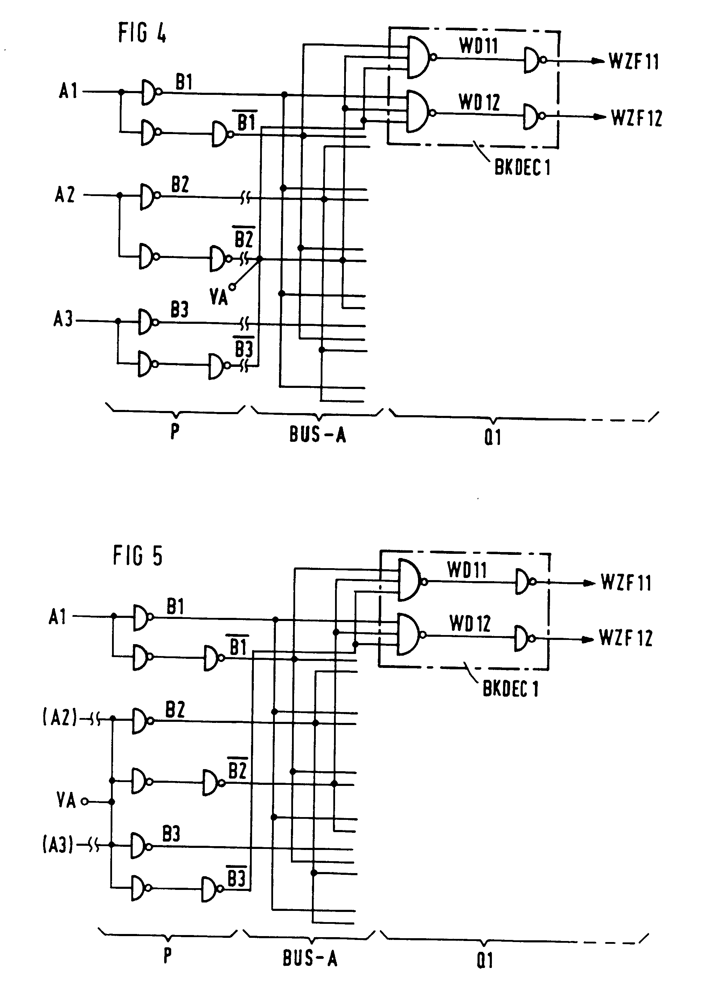

In den Figuren 4 bis 7 ist in Form schematisierter Schaltplane beispielhaft für den ersten Quadranten Q1 des herzustellenden Halbleiterspeichers dargestellt, welche elektrischen Verbindungen beim Durchführen des erfindungsgemäßen Verfahrens in verschiedenen vorteilhaften Ausführungsformen des Verfahrens sich bezüglich des jeweiligen betreffenden Blockdecoders BKDEC1 ergeben. Da gemäß den vorstehenden Ausführungen im Beispiel nur zwei Zellenfelder ZF11, ZF12 für den ersten Quadranten Q1 übernommen werden sollen vom Layout des Halbleiterspeichers der Nachfolgegeneration, enthält der für den ersten Quadranten Q1 zuständige Block-decoder BKDEC1 auch lediglich zwei (in den Zellenfeldern ZF11, ZF12 angeordnete) Blockdecodereinheiten WD11, WD12. Entsprechendes gilt für die übrigen Quadranten Q2, Q3, Q4. Während beim Blockdecoder BKDEC1 der Halbleiterspeicher der Nachfolgegeneration eine Decodierung "1 aus 8" (ein Quadrant weist 8 Zellenfelder auf; vergleiche Figur 3) erfolgt, ist bei dem herzustellenden Halbleiterspeicher aufgrund des geringeren Adressenumfangs lediglich eine Decodierung "1 aus 2" nötig. Zur Decodierung notwendig ist deshalb lediglich das eine Adreßsignal Al bzw. das davon abgeleitete, zueinander komplementäre interne Adreßsignalpaar B1, $\overline{B1}$. Der Blockdecoder BKDEC1 ist deshalb im Betrieb so anzusteuern, daß die (zur Decodierung nicht benötigten) internen Adreßsignale B2, $\overline{B2}$, B3 $\overline{B3}$, bzw. die Leitungen für die nicht vorhandenen externen Adreßsignale A2, A3 keine Auswirkungen haben können auf die Blockdecodereinheiten WDII, WD12. Entsprechendes gilt für die Blockdecoder BKDEC2...4 der restlichen Quadranten Q2, Q3, Q4.

In einer ersten Ausführungsform des erfindungsgemäßen Verfahrens ist deshalb gemäß Figur 4 vorgesehen, daß die mit den Blockdecodereinheiten WDII, WD12 zwar verbundenen, aber für die Decodierung nicht benötigten Leitungen $\overline{B2}$, $\overline{B3}$ der internen Adreßsignalpaare B2, $\overline{B2}$, B3, $\overline{B3}$ mit einem Punkt verbunden werden, welcher beim Betrieb eines so hergestellten Halbleiterspeichers ein elektrisches Potential VA führt. Das Potential VA kann dabei ein dem Halbleiterspeicher zum Betrieb von extern zuführbares elektrisches Versorgungspotential sein oder ein im Betrieb chipintern erzeugtes elektrisches Potential. Wenn, wie im Beispiel gewählt, die Blockdecodereinheiten WD11 ... NAND-Gatter (oder auch AND-Gatter) sind, so weist das Potential VA einen Wert auf, der größer ist als das Bezugspotential des Halbleiterspeichers, meist mit Masse bezeichnet. Die Verwendung von NOR- bzw. OR-Gattern bei den Blockdecodereinheiten WD11... ist statt dessen das Bezugspotential des Halbleiterspeichers zu verwenden, was für den Fachmann selbstverständlich ist. Die dargestellten Blockdecodereinheiten WD11, WD12 decodieren dann lediglich das eine interne Adreßsignalpaar B1, $\overline{B1}$ bzw. das eine externe Adreßsignal A1.

Die Leitungen der internen Adressignale $\overline{B2}$, $\overline{B3}$ sowie ggf. auch die der internen Adressignale B2, B3 sind dabei elektrisch getrennt vom Bereich der peripheren Schaltungsteile P vorzusehen. Dadurch wird es möglich, so frei werdende Schaltungsteile der peripheren Schaltungsteile P für andere Zwecke als den der Führung von Adressignalen vorzusehen.

Da der herzustellende Halbleiterspeicher einen geringeren Adreßraum aufweist als der Speicher der Nachfolgegeneration, dessen Layout beim erfindungsgemäßen Verfahren ja zu verwenden ist, treten die beim Speicher der Nachfolgegeneration auftretenden externen Adreßsignale A2, A3 (die Numerierung als solche ist willkürlich gewählt) bei der Ansteuerung des herzustellenden Speichers mit der (geringeren) vorgegebenen Speicherkapazität nicht auf, da sie nicht an den Halbleiterspeicher angelegt werden. Deshalb ist auch eine Ausführung nach Figur 5 möglich: Dabei werden einerseits die Leitungen der für die Adressierung nicht benötigten externen Adreßsignale A2, A3 mit dem obengenannten im Betrieb das Versorgungspotential VDD führenden Punkt verbunden und andererseits werden diese Leitungen elektrisch getrennt geführt von sonstigen Schaltungsteilen der peripheren Schaltungsteile P wie z. B. entsprechenden Adreßpuffern.

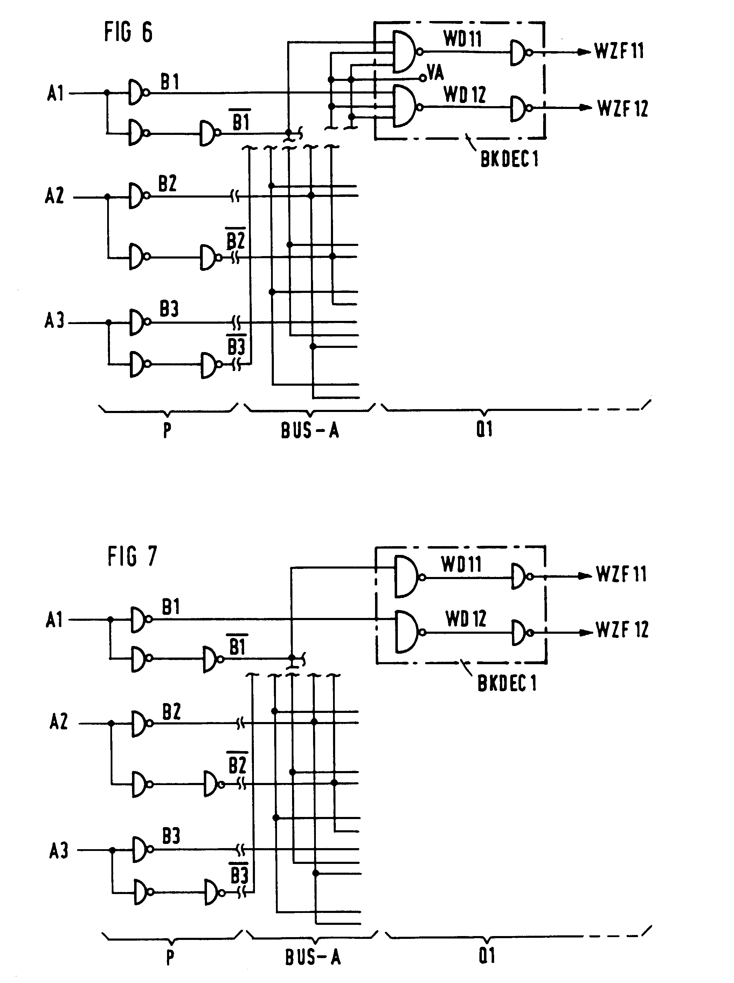

Bei beiden Ausführungsformen (Fig. 4, 5) wird also erreicht, daß bei jeder der Blockdecodereinheiten WD11, WD12 des Blockdecoders BKDEC1 zwei Eingänge, die beim Halbleiterspeicher der Nachfolgegeneration mit internen Adreßsignalen ($\overline{B2}$, $\overline{B3}$) beaufschlagt sind im Betrieb (siehe Figur 3), beim herzustellenden Halbleiterspeicher im Betrieb das Versorgungspotential VDD aufweisen. Entsprechendes gilt auch für die Ausführungsform nach Figur 6: Dabei werden besagte Eingänge der Blockdecodereinheiten WD11, WD12 noch im Bereich des entsprechenden Quadranten (hier: Q1) mit dem Punkt verbunden, welcher im Betrieb das Versorgungspotential VDD führt. Dies hat dann für das Layout insgesamt folgenden Vorteil: Die Leitungen für die (im Betrieb sowieso nicht vorhandenen) internen Adreßsignale B2, $\overline{B2}$, B3, $\overline{B3}$ können gänzlich eingespart werden, zumindest im Bereich des betreffenden Busses (hier: BUS-A), was dann eine zusätzliche Flächenersparnis ergibt, oder sie können für andere Zwecke verwendet werden. Diese Einsparmöglichkeit ist in Figur 6 angedeutet durch Unterbrechungen der entsprechenden Leitungen im Bereich des Busses BUS-A.

Bei der Darstellung in Figur 7 schließlich weist der als Adreßdecoder fungierende Blockdecoder BKDEC1 lediglich noch Eingänge für die zum Dekodieren notwendigen internen Adreßleitungen B1, $\overline{B1}$ auf, während für die zum Decodieren nicht notwendigen Adreßleitungen B2, $\overline{B2}$, B3, $\overline{B3}$ keine Eingänge vorgesehen sind.

In einem Fall, wie in Figur 7 dargestellt, bei dem ein Blockdecoder BKDEC1 nur noch Eingänge für ein einziges Paar zueinander komplementärer interner Adreßleitungen B1, $\overline{B1}$ aufweisen würde bei der Erstellung des Layouts, ist es dann weiterhin vorteilhaft, da noch mehr Platz sparend, wenn die Adreßdecoderstufe "Blockdecoder" (BKDEC1) ganz eingespart wird und statt dessen die eine interne Adreßleitung B1 als zusätzlicher Eingang beim Wortleitungsdecoder des einen Zellenfeldes ZF11 angeordnet wird und die andere interne Adreßleitung $\overline{B1}$ als zusätzlicher Eingang beim Wortleitungsdecoder des anderen Zellenfeldes ZF12 angeordnet wird. Auf diese Art und Weise findet also eine Reduzierung von Decoderstufen statt.

Halbleiterspeicher wie das im Beispiel genannte 16MB-DRAM haben bekanntlich Adreßeingänge für Adreßsignale, die im Betrieb im Multiplexverfahren anliegen. Dies bedeutet, daß im Betrieb während einer Taktperiode zu einem ersten Zeitpunkt Adreßsignale für Wortleitungen anliegen und daß zu einem zweiten Zeitpunkt Adreßsignale für Bitleitungen anliegen. Wenn man nun mittels des erfindungsgemäße Verfahrens einen 4MB-Halbleiterspeicher herstellt, welcher ein Layout aufweist, das aus dem Layout des 16MB-Speichers erstellt wurde, so weist der 4MB-Speicher die selbe Anzahl von Bitleitungen auf wie der 16MB-Speicher (die Layouts der einzelnen Zellenfelder als solche sind ja unverändert belassen), jedoch nur 1/4 der Anzahl der Wortleitungen (da nur 1/4 der Zellenfelder verwendet werden). Dies bedeutet, daß man beim 4MB-Speicher zur Bitleitungsdecodierung genau so viele interne Adreßleitungen benötigt wie beim 16MB-Speicher, während man zur Wortleitungsdecodierung zwei Adreßleitungspaare weniger benötigt. Bezüglich der notwendigen Adreßpuffer im herzustellenden 4MB-Speicher und der zum Betreiben vorhandenen externen Adreßsignale ergibt sich also folgende Situation: Einerseits werden zur Bitleitungsdecodierung gleich viele interne Adreßleitungspaare (und damit Adreßpuffer) benötigt wie beim 16MB-Speicher, während an externen Bitleitungsadreßsignalen ein Signal weniger zur Verfügung steht als beim 16MB-Speicher. Andererseits werden zur Wortleitungsdecodierung zwei interne Adreßleitungspaare (und damit Adreßpuffer) weniger benötigt als beim 16MB-Speicher, während lediglich ein einziges externes Wortleitungsadreßsignal weniger zur Verfügung steht als beim 16MB-Speicher. Somit ist also ein Wortleitungsadreßpuffer "frei", d.h. er wird beim 4 MB-Speicher nicht benötigt für Wortleitungen, obwohl aufgrund des erfindungsgemäßen Verfahrens vorhanden. Vorteilhafterweise wird nun vorgeschlagen, diesen Wortleitungsadreßpuffer für Adressignale zur Decodierung von Bitleitungen zu verwenden.

## Patentansprüche

1. Verfahren zum Herstellen eines integrierten Halbleiterspeichers mit vorgegebener Speicherkapazität, wobei das zum Herstellen des Halbleiterspeichers der vorgegebenen Speicherkapazität notwendige Layout erstellt wird unter Verwendung des Layouts eines Halbleiterspeichers, welcher eine größere Speicherkapazität aufweist als die vorgegebene Speicherkapazität, wobei das Layout des Halbleiterspeichers mit der größeren Speicherkapazität mehrere Speicherzellenfelder aufweist (ZF11...ZF18, ZF21...ZF28, ZF31...ZF38, ZF41...ZF48), und daß nur ein der vorgegebenen Speicherkapazität entsprechender Teil (ZF11, ZF12, ZF21, ZF22, ZF31, ZF32, ZF41, ZF42) dieser Speicherzellenfelder (ZF11... ZF18, ZF21...ZF28, ZF31...ZF38, ZF41...ZF48) verwendet wird, um das Layout des Halbleiterspeichers vorgegebener Speicherkapazität herzustellen.

2. Verfahren nach Anspruch 1,
   **gekennzeichnet durch** folgende Merkmale:

- das Layout peripherer Schaltungsteile (P) des integrierten Halbleiterspeichers, welcher eine höhere als die vorgegebene Speicherkapazität aufweist, wird in dem Umfang verwendet, indem es für die Funktion der verwendeten Speicherzellenfelder (ZF11...ZF42) notwendig ist,
- Layouts von Speicherzellenfeldern (ZF11, ZF12, ZF21, ZF22, ZF31, ZF32, ZF41, ZF42) des Halbleiterspeichers der höheren Speicherkapazität werden in einer der vorgegeben Speicherkapazität entsprechenden Anzahl verwendet,
- die Layouts der peripheren Schaltungsteile (P) und die der verwendeten Speicherzellenfelder (ZF11 ... ZF42) werden relativ zueinander genauso angeordnet wie sie beim Halbleiterspeicher der höhere Speicherkapazität relativ zueinander angeordnet sind,
- Layouts von Busleitungen (BUS-A, BUS-B) des Halbleiterspeichers der höheren Speicherkapazität werden beim Layout des Halbleiterspeichers der vorgegebenen Speicherkapazität in dem Umfang verwendet, in dem sie für die Funktion der verwendeten Speicherzellenfelder (ZF11 ... ZF42) notwendig sind.

3. Verfahren nach Anspruch 1 oder 2,
   **dadurch gekennzeichnet**,

   daß solche Adreßleitungen (A2, A3; B2, $\overline{B2}$, B3, $\overline{B3}$), die aufgrund der vorgegebenen Speicherkapazität zur Decodierung von Adreßsignalen für die verwendeten Speicherzellenfelder (ZF11 ... ZF42) nicht benötigt werden, mit einer elektrischen Potentialquelle verbunden werden, die beim Betreiben des Halbleiterspeichers einen elektrischen Pegel (VA) aufweist, welcher die Decodierung von Adreßsignalen solcher Adreßleitungen (A1; B1, $\overline{B1}$) nicht beeinflußt, die zur Decodierung für die verwendeten Speicherzellenfelder (ZF11 ... ZF42) notwendig sind.

4. Verfahren nach Anspruch 1 oder 2,
   **dadurch gekennzeichnet**,

   daß bei Blockdecodereinheiten (WD11, WD12, WD21 ... WD42) solche Eingänge, die aufgrund der vorgegebenen Speicherkapazität zur Decodierung von Adreßsignalen für die verwendeten Speicherzellenfelder (ZF11 ... ZF42) nicht benötigt werden, mit einer elektrischen Potentialquelle verbunden werden, die beim Betreiben des Halbleiterspeichers einen elektrischen Pegel (VA) aufweist, welcher die Decodierung von Adreßsignalen solcher Adreßleitungen (A1; B1, $\overline{B1}$) nicht beeinflußt, die zur Decodierung für die verwendeten Speicherzellenfelder (ZF11 ... ZF 42) notwendig sind.

5. Verfahren nach Anspruch 1 oder 2,
   **dadurch gekennzeichnet,**

   daß bei Adreßdecodern anstelle der beim Halbleiterspeicher der höheren Speicherkapazität notwendigen Anzahl von Eingängen für interne Adreßleitungen (B1, $\overline{B1}$, B2, $\overline{B2}$, B3, $\overline{B3}$) nur eine solche Anzahl von Eingängen für interne Adreßleitungen (B1, $\overline{B1}$) verwendet wird, wie sie aufgrund der vorgegebenen Speicherkapazität notwendig ist.

6. Verfahren nach Anspruch 1 oder 2,
   **dadurch gekennzeichnet,**

   daß im dem Fall, in dem das Layout des Halbleiterspeichers mit der höheren Speicherkapazität mehr als eine Stufe für Adreßdecoder aufweist, für den Halbleiterspeicher der vorgegebenen Speicherkapazität eine geringere Anzahl von Stufen für Adreßdecoder verwendet wird.

7. Verfahren nach einem der vorhergehenden Ansprüche,
   **dadurch gekennzeichnet,**

   daß wenigstens einer der Wortleitungsdecoder, der beim Halbleiterspeicher der größeren Kapazität zur Decodierung eines Wortleitungssignals verwendet wird, beim Halbleiterspeicher der vorgegebenen Speicherkapazität zur Decodierung eines Bitleitungssignals verwendet wird.

**EP 0 578 970 B1**

## Claims

1. Method for fabricating an integrated semiconductor memory with a predetermined storage capacity, in which the layout necessary for fabricating the semiconductor memory having the predetermined storage capacity is created using the layout of a semiconductor memory having a larger storage capacity than the predetermined storage capacity, in which the layout of the semiconductor memory having the larger storage capacity has a plurality of memory cell arrays (ZF11...ZF18, ZF21...ZF28, ZF31...ZF38, ZF41...ZF48), and in which only a portion (ZF11, ZF12, ZF21, ZF22, ZF31, ZF32, ZF41, ZF42) of these memory cell arrays (ZF11...ZF18, ZF21...ZF28, ZF31... ZF38, ZF41...ZF48), which portion corresponds to the predetermined storage capacity, is used to fabricate the layout of the semiconductor memory having the predetermined storage capacity.

2. Method according to Claim 1,
   characterized by the following features:

   - the layout of peripheral circuit sections (P) of the integrated semiconductor memory having a higher storage capacity than the predetermined storage capacity is used to the extent to which it is necessary for the function of the memory cell arrays (ZF11...ZF42) used,
   - layouts of memory cell arrays (ZF11, ZF12, ZF21, ZF22, ZF31, ZF32, ZF41, ZF42) of the semiconductor memory having the higher storage capacity are used in a number corresponding to the predetermined storage capacity,
   - the layouts of the peripheral circuit sections (P) and those of the memory cell arrays (ZF11 ... ZF42) used are arranged relative to one another in exactly the same way that they are arranged relative to one another in the semiconductor memory having the higher storage capacity,
   - layouts of bus lines (BUS-A, BUS-B) of the semiconductor memory having the higher storage capacity are used in the layout of the semiconductor memory having the predetermined storage capacity to the extent to which they are necessary for the function of the memory cell arrays (ZF11 ... ZF42) used.

3. Method according to Claim 1 or 2,
   characterized in that those address lines (A2, A3; B2, $\overline{B2}$, B3, $\overline{B3}$), which are not required, on account of the predetermined storage capacity, for decoding address signals for the memory cell arrays (ZF11 ... ZF42) used are connected to an electrical potential source which, during operation of the semiconductor memory, has an electrical level (VA) which does not influence the decoding of address signals of those address lines (A1; B1, $\overline{B1}$) which are necessary for decoding for the memory cell arrays (ZF11 ... ZF42) used.

4. Method according to Claim 1 or 2,
   characterized in that in block decoder units (WD11, WD12, WD21 ... WD42), those inputs which are not required, on account of the predetermined storage capacity, for decoding address signals for the memory cell arrays (ZF11 ... ZF42) used are connected to an electrical potential source which, during operation of the semiconductor memory, has an electrical level (VA) which does not influence the decoding of address signals of those address lines (A1; B1, $\overline{B1}$) which are necessary for decoding for the memory cell arrays (ZF11 ... ZF42) used.

5. Method according to Claim 1 or 2,
   characterized in that in address decoders, instead of the number of inputs for internal address lines (B1, $\overline{B1}$, B2, $\overline{B2}$, B3, $\overline{B3}$) that is necessary in the semiconductor memory having the higher storage capacity, only such a number of inputs for internal address lines (B1, $\overline{B1}$) as is necessary on the basis of the predetermined storage capacity is used.

6. Method according to Claim 1 or 2,
   characterized in that in the case where the layout of the semiconductor memory having the higher storage capacity has more than one stage for address decoders, a smaller number of stages for address decoders is used for the semiconductor memory having the predetermined storage capacity.

7. Method according to one of the preceding claims, characterized in that at least one of the word line decoders which is used for decoding a word line signal in the semiconductor memory having the larger capacity is used for decoding a bit line signal in the semiconductor memory having the predetermined storage capacity.

**Revendications**

1. Procédé de fabrication d'une mémoire à semi-conducteurs intégrée ayant une capacité de stockage déterminée à l'avance, dans lequel on forme le layout nécessaire à la fabrication de la mémoire à semi-conducteurs ayant la capacité de stockage déterminée à l'avance en utilisant le layout d'une mémoire à semi-conducteurs qui a une capacité de stockage plus grande que la capacité de stockage déterminée à l'avance, le layout de la mémoire à semi-conducteurs qui a la capacité de stockage plus grande comportant plusieurs champs de cellules de mémoire (ZF11 à ZF18, ZF21 à ZF28, ZF31 à ZF38, ZF41 à ZF48), et dans lequel on utilise seulement une partie (ZF11, ZF12, ZF21, ZF22, ZF31, ZF32, ZF41, ZF42), correspondant à la capacité de stockage déterminée à l'avance, de ces champs de cellules de mémoire (ZF11 à ZF18, ZF21 à ZF28, ZF31 à ZF38, ZF41 à ZF48) pour fabriquer le layout de la mémoire à semi-conducteurs ayant la capacité de stockage déterminée à l'avance.

2. Procédé selon la revendication 1,
   caractérisé par le fait que :

   - on utilise le layout de parties de circuits périphériques (P) de la mémoire à semi-conducteurs intégrée qui a une capacité de stockage plus grande que la capacité de stockage déterminée à l'avance seulement dans la mesure où c'est nécessaire pour le fonctionnement des champs de cellules de mémoire utilisés (ZF11 à ZF42),
   - on utilise un certain nombre, correspondant à la capacité de stockage déterminée à l'avance, de layouts de champs de cellules de mémoire (ZF11, ZF12, ZF21, ZF22, ZF31, ZF32, ZF41, ZF42), de la, mémoire à semi-conducteurs ayant la capacité de stockage plus grande,
   - on dispose les uns par rapport aux autres les layouts des parties de circuits périphériques (P) et ceux des champs de cellules de mémoire utilisés (ZF11 à ZF42) exactement comme ils sont agencés les uns par rapport aux autres dans la mémoire à semi-conducteurs ayant la capacité de stockage plus grande,
   - on utilise des layouts de lignes de bus (BUS-A, BUS-B) de la mémoire à semi-conducteurs ayant la capacité de stockage plus grande pour le layout de la mémoire à semi-conducteurs ayant la capacité de stockage déterminée à l'avance dans la mesure où ils sont nécessaires au fonctionnement des champs de cellules de mémoire utilisés (ZF11 à ZF42).

3. Procédé selon la revendication 1 ou 2,
   caractérisé par le fait que

   des lignes d'adresses (A2, A3 ; B2, $\overline{B2}$, B3, $\overline{B3}$) qui, en raison de la capacité de stockage déterminée à l'avance, ne sont pas nécessaires au décodage de signaux d'adresses pour les champs de cellules de mémoire utilisés (ZF11 à ZF42) sont reliées à une source de potentiel électrique qui présente lors de l'exploitation de la mémoire à semi-conducteurs un niveau électrique (VA) qui n'influence pas le décodage de signaux d'adresses de lignes d'adresses (A1 ; B1, $\overline{B1}$) qui sont nécessaires au décodage pour les champs de cellules de mémoire utilisés (ZF11 à ZF42).

4. Procédé selon la revendication 1 ou 2,
   caractérisé par le fait que,

   en ce qui concerne des unités de décodeurs de blocs (WD11, WD12, WD21 à WD42), des entrées qui ne sont pas nécessaires au décodage de signaux d'adresses pour les champs de cellules de mémoire utilisés (ZF11 à ZF42) en raison de la capacité de stockage déterminée à l'avance sont reliées à une source de potentiel électrique qui présente lors de l'exploitation de la mémoire à semi-conducteurs un niveau électrique (VA) qui n'influence pas le décodage de signaux d'adresses de lignes d'adresses (A1 ; B1, B1) qui sont nécessaires au décodage pour les champs de cellules de mémoire utilisés (ZF11 à ZF42).

5. Procédé selon la revendication 1 ou 2,
   caractérisé par le fait,

   en ce qui concerne des décodeurs d'adresses, on utilise à la place du nombre, nécessaire pour la mémoire à semi-conducteurs de la capacité de stockage plus grande, d'entrées destinées à des lignes d'adresses internes (B1, $\overline{B1}$, B2, $\overline{B2}$, B3, $\overline{B3}$) seulement le nombre, nécessaire pour la capacité de stockage déterminée à l'avance, d'entrées destinées à des lignes d'adresses internes (B1, $\overline{B1}$).

6. Procédé selon la revendication 1 ou 2,

caractérisé par le fait que,

dans le cas où le layout de la mémoire à semi-conducteurs ayant la capacité de stockage plus grande, comporte plus d'un étage pour des décodeurs d'adresses, on utilise pour la mémoire à semi-conducteurs ayant la capacité de stockage déterminée à l'avance un plus petit nombre d'étages pour des décodeurs d'adresses.

7. Procédé selon l'une des revendications précédentes,
caractérisé par le fait que

on utilise au moins l'un des décodeurs de lignes de mots, qui est utilisé pour le décodage d'un signal de lignes de mots dans le cas de la mémoire à semi-conducteurs ayant la capacité de stockage plus grande, pour le décodage d'un signal de lignes de bits dans le cas de la mémoire à semi-conducteurs ayant la capacité de stockage déterminée à l'avance.

FIG 1

| Q2 | | | | | | | | | | Q1 | | | | | | | |
|---|---|---|---|---|---|---|---|---|---|---|---|---|---|---|---|---|---|

ZF 28 | ZF 27 | ZF 26 | ZF 25 | ZF 24 | ZF 23 | ZF 22 | ZF 21

ZF 11 | ZF 12 | ZF 13 | ZF 14 | ZF 15 | ZF 16 | ZF 17 | ZF 18

WD 28 | WD 27 | WD 26 | WD 25 | WD 24 | WD 23 | WD 22 | WD 21    BKDEC 2

WD 11 | WD 12 | WD 13 | WD 14 | WD 15 | WD 16 | WD 17 | WD 18    BKDEC 1

BUS-B

BUS-A

WD 38 | WD 37 | WD 36 | WD 35 | WD 34 | WD 33 | WD 32 | WD 31    BKDEC 3

WD 41 | WD 42 | WD 43 | WD 44 | WD 45 | WD 46 | WD 47 | WD 48    BKDEC 4

P

ZF 38 | ZF 37 | ZF 36 | ZF 35 | ZF 34 | ZF 33 | ZF 32 | ZF 31

ZF 41 | ZF 42 | ZF 43 | ZF 44 | ZF 45 | ZF 46 | ZF 47 | ZF 48

Q3

Q4

EP 0 578 970 B1

# FIG 2

# FIG 3

FIG 4

FIG 5

FIG 6

FIG 7